# EUROPEAN PATENT APPLICATION

(11) **EP 4 328 986 A1**
(43) Date of publication of application: **28.02.2024**
(21) Application number: 22791449.6
(22) Date of filing: 22.03.2022
(51) Int. Cl.: H01L 41/113, B32B 7/025, B32B 15/01, B32B 15/08, G01L 1/16, H01L 41/187

(54) **TRANSPARENT ELECTRICALLY CONDUCTIVE PIEZOELECTRIC LAMINATE FILM**

(30) Priority: 20.04.2021 JP 2021071061
(71) Applicant: Kureha Corporation, Chuo-ku Tokyo 103-8552 (JP)
(72) Inventor: IMAJI, Makoto, Tokyo 103-8552 (JP)
(74) Representative: Zimmermann & Partner Patentanwälte mbB
(86) International application number: PCT/JP2022/013198
(87) International publication number: WO 2022/224671

(57) **Abstract**

Provided is a transparent conductive piezoelectric laminate film that achieves high transparency and low resistance. The present invention relates to a transparent conductive piezoelectric laminate film, wherein a piezoelectric film, a first conductor layer, a metal layer, and a second conductor layer are layered in this order, and the metal layer contains silver or a silver alloy.

## Description

### TECHNICAL FIELD

The present invention relates to a transparent conductive piezoelectric laminate film and a device including the same.

### BACKGROUND ART

Touch panels are widely used as devices with which information can be input by directly touching an image display unit. A representative type of touch panel is a capacitive touch panel which utilizes a change in current-carrying capacity between a transparent electrode and a finger (Patent Document 1).

A transparent conductive film is used in a position detection sensor utilized in a touch panel. For example, low resistance and high transmittance are achieved by forming an indium tin oxide (ITO) film on a PET film and then increasing the crystallinity of ITO by heat treatment (at or around 150°C).

### Citation List

### Patent Document

Patent Document 1: JP 05-324203 A

### SUMMARY OF INVENTION

### TECHNICAL PROBLEM

Recently, technology for simultaneously detecting a position and pressure when an operation surface is touched by a finger or the like has been attracting rising attention, and achieving such technology by combining pressure detection sensors, which are piezoelectric sensors, has been proposed.

However, in a transparent conductive piezoelectric film used in a piezoelectric sensor, such as a PET film, the resistance of the film deteriorates and the color of the film is lost when the film is subjected to heat treatment at a high temperature. Thus, it is difficult to use a transparent conductive piezoelectric film in a touch panel.

The present invention has been made in view of the above problems, and an object of the present invention is to provide a transparent conductive piezoelectric laminate film that achieves high transparency and low resistance.

### SOLUTION TO PROBLEM

The present inventors found that the above problems are solved by a transparent conductive piezoelectric laminate film in which a piezoelectric film, a first conductor layer, a metal layer containing silver or a silver alloy, and a second conductor layer are layered, and arrived at the present invention. Specifically, the present invention relates to the following.

The present invention relates to a transparent conductive piezoelectric laminate film, wherein a piezoelectric film, a first conductor layer, a metal layer, and a second conductor layer are layered in this order, and the metal layer contains silver or a silver alloy.

The transparent conductive piezoelectric laminate film preferably has a diffraction peak in a range of 35° ± 2° in X-ray diffraction measurement.

The transparent conductive piezoelectric laminate film preferably has a surface resistance of 30 Ω/sq or less as measured from the second conductor layer side.

The piezoelectric film preferably contains a fluorine-based resin.

The thickness of the metal layer is preferably from 1 to 12 nm.

The total light transmittance of the transparent conductive piezoelectric laminate film is preferably 85% or more.

In the transparent conductive piezoelectric laminate film, b* in a L*a*b* color system is preferably from -3 to 3.

The transparent conductive piezoelectric laminate film preferably further includes a transparent coating layer on a surface of the piezoelectric film, the surface on the first conductor layer side of the piezoelectric film.

The transparent coating layer preferably contains a fine particle.

The present invention also relates to a device including the transparent conductive piezoelectric laminate film.

### ADVANTAGEOUS EFFECTS OF INVENTION

According to the present invention, there can be provided a transparent conductive piezoelectric laminate film that achieves high transparency and low resistance.

### BRIEF DESCRIPTION OF DRAWINGS

FIG. 1 is a cross-sectional view schematically illustrating an embodiment of a transparent conductive piezoelectric laminate film according to the present invention.
FIG. 2 is a cross-sectional view schematically illustrating another embodiment of a transparent conductive piezoelectric laminate film according to the present invention.
FIG. 3 is a graph showing a result of X-ray diffraction measurement of Example 1.

### DESCRIPTION OF EMBODIMENTS

Hereinafter, embodiments of the present invention (hereinafter referred to as "the present embodiment") will be described in detail with reference to the drawings, but the present invention is not limited to these embodiments, and various modifications can be made without departing from the gist of the present invention.

### Transparent Conductive Piezoelectric Laminate Film

In a transparent conductive piezoelectric laminate film according to an embodiment of the present invention, a piezoelectric film, a first conductor layer, a metal layer, and a second conductor layer are layered in this order, and the metal layer contains silver or a silver alloy.

In the present specification, "laminate" means that each layer is laminated in order and another layer may be laminated between the layers.

### Properties of Transparent Conductive Piezoelectric Laminate Film

The transparent conductive piezoelectric laminate film preferably has a diffraction peak in a range of 35° ± 2° in X-ray diffraction measurement. Such a characteristic eliminates the need for high-temperature heat treatment for improving conductivity, facilitates prevention of performance deterioration of the piezoelectric film, and makes it easier to provide a transparent conductive piezoelectric laminate film that achieves high transparency and low resistance. In the present specification, the method of the X-ray diffraction measurement is performed by an in-plane method. In the present specification, "has a diffraction peak in a range of 35° ± 2°" means that when a straight line connecting a diffraction intensity (I₃₁) at a diffraction angle (2θ) of 31° and a diffraction intensity (I₃₉) at a diffraction angle (2θ) of 39° is set as a baseline, a mountain-like portion with a diffraction intensity twice or more (preferably three times or more) a baseline diffraction intensity (defined as an average of I₃₁ and I₃₉) is observed in the range of 35° ± 2°.

A method of obtaining the above characteristic is not particularly limited, and an example of the method is forming a metal layer containing a silver alloy.

The surface resistance measured from the second conductor layer side of the transparent conductive piezoelectric laminate film is preferably 30 Ω/sq or less and more preferably 20 Ω/sq or less. The lower limit of the surface resistance is not particularly limited and is, for example, 1 Ω/sq.

In the present specification, the surface resistance is measured in accordance with JIS K 7194.

The total light transmittance of the transparent conductive piezoelectric laminate film is preferably 80% or more and more preferably 85% or more. The upper limit of the total light transmittance is not particularly limited and is, for example, 95%.

In the present specification, the total light transmittance is measured in accordance with JIS K 7361-1.

The haze value of the transparent conductive piezoelectric laminate film is preferably 1.8% or less, more preferably 1.0% or less, and still more preferably 0.7% or less. The lower limit of the haze value is not particularly limited.

In the present specification, the haze value is measured in accordance with JIS K 7136.

L* of the transparent conductive piezoelectric laminate film is preferably 80 or more and more preferably 90 or more. The upper limit of L* is not particularly limited.
a* of the transparent conductive piezoelectric laminate film is preferably from - 3 to 3 and more preferably from -2 to 2.
b* of the transparent conductive piezoelectric laminate film is preferably from - 3 to 3 and more preferably from -2 to 2.
In the present specification, L*, a*, and b* in the L*a*b* color system are measured in accordance with JIS Z 8722.

The thickness of the transparent conductive piezoelectric laminate film is preferably from 10 to 200 µm and more preferably from 20 to 100 µm. A thickness of 10 µm or greater tends to provide sufficient mechanical strength. In addition, a thickness of 200 µm or less provides sufficient transparency and thus tends to facilitate use in optical applications.

Next, each layer of the transparent conductive laminate film will be described with reference to drawings.

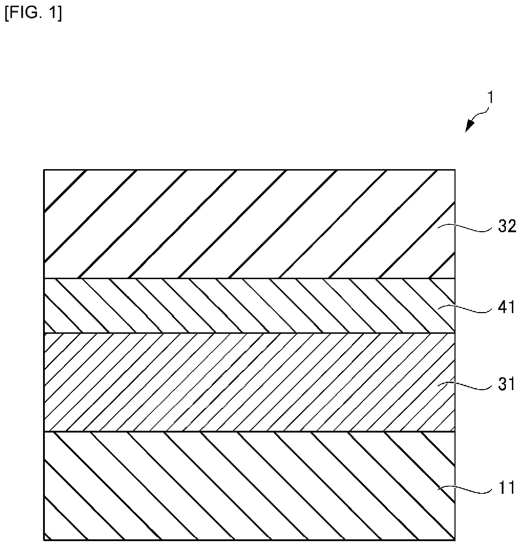

FIG. 1 is a cross-sectional view schematically illustrating an embodiment of the transparent conductive piezoelectric laminate film. In a transparent conductive piezoelectric laminate film 1, a piezoelectric film 11, a first conductor layer 31, a metal layer 41, and a second conductor layer 32 are layered in this order. That is, the metal layer 41 is disposed between a pair of conductor layers. Of the pair of conductor layers, the layer disposed on the piezoelectric film 11 side is referred to as the first conductor layer 31, and the layer disposed farther from the piezoelectric film 11 than the first conductor layer 31 is referred to as the second conductor layer 32.

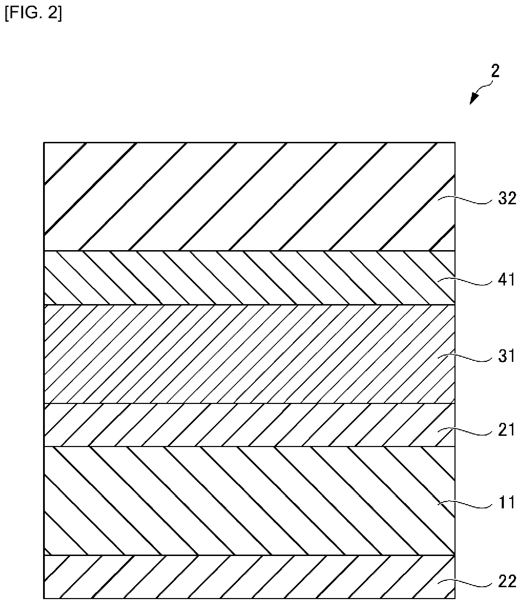

FIG. 2 is a cross-sectional view schematically illustrating another embodiment of the transparent conductive piezoelectric laminate film of the present invention. A transparent conductive piezoelectric laminate film 2 is different from the transparent conductive piezoelectric laminate film 1 in that the transparent conductive piezoelectric laminate film 2 includes a pair of transparent coating layers (a first transparent coating layer 21 and a second transparent coating layer 22) to sandwich the piezoelectric film 11. Other configurations are the same as those of the transparent conductive piezoelectric laminate film 1.

### Piezoelectric Film

The piezoelectric film 11 is a film (thin film) with piezoelectricity (a property of converting an applied force to a voltage or a property of converting an applied voltage to a force).

Examples of the piezoelectric film 11 include fluorine-based resins; vinylidene cyanide-based polymers; odd-numbered nylons, such as nylon 9 and nylon 11; helical chiral macromolecules, such as polylactic acid; polyhydroxycarboxylic acids, such as polyhydroxybutyrate; cellulose-based derivatives; and polyureas.

Examples of the fluorine-based resin include poly(vinylidene fluoride) (PVDF), vinylidene fluoride-based copolymers (e.g., vinylidene fluoride/trifluoroethylene copolymers, vinylidene fluoride/trifluoroethylene/chlorotrifluoroethylene copolymers, hexafluoropropylene/vinylidene fluoride copolymers, perfluorovinyl ether/vinylidene fluoride copolymers, tetrafluoroethylene/vinylidene fluoride copolymers, hexafluoropropylene oxide/vinylidene fluoride copolymers, hexafluoropropylene oxide/tetrafluoroethylene/vinylidene fluoride copolymers, and hexafluoropropylene/tetrafluoroethylene/vinylidene fluoride copolymers); tetrafluoroethylene-based polymers; and chlorotrifluoroethylene-based polymers. One of these can be used individually, or two or more can be used in combination.

Among these, in terms of high piezoelectricity, weather resistance, heat resistance, and the like to be obtained, a fluorine-based resin is preferred, and poly(vinylidene fluoride) and/or a vinylidene fluoride-based copolymer is more preferred.

The piezoelectric film 11 may further contain a commonly used additive (such as a filler and/or a surfactant).

The thickness of the piezoelectric film 11 is preferably from 10 to 200 µm and more preferably from 20 to 100 µm. A thickness of 10 µm or greater tends to provide sufficient mechanical strength. In addition, a thickness of 200 µm or less provides sufficient transparency and thus tends to facilitate use in optical applications.

### Conductor Layer

The conductor layers (the first conductor layer 31 and the second conductor layer 32) are transparent layers exhibiting conductivity. Forming the metal layer as a thin film to transmit visible light would reduce the stability against oxygen, water vapor, heat, and the like. However, sandwiching the metal layer with the conductor layers that have high transparency and do not impair conductivity improves the environmental resistance.

Examples of the raw material constituting the conductor layers include metal oxides, such as indium tin oxide (ITO), indium oxide, tin oxide, zinc oxide, zinc indium oxide, aluminum oxide, and gallium oxide; and polythiophene-based and polyaniline-based conductive organic macromolecules. One of these can be used individually, or two or more can be used in combination.

Of these materials, from the viewpoint of increasing the transmittance of light in the visible region of a silver thin film, a metal oxide with a high dielectric constant is preferred, and indium tin oxide is more preferred.

The conductor layers may each contain a trace component or an inevitable component to the extent that its function is not impaired.

The thickness of the conductor layer is preferably from 10 to 55 nm and more preferably from 20 to 45 nm. A thickness in the above numerical value ranges facilitates higher transmittance of visible light.

Of the conductor layers, the first conductor layer 31 provided on the piezoelectric film 11 side and the second conductor layer 32 provided away from the piezoelectric film 11 may be the same or different in terms of thickness, structure, and composition.

A wiring electrode or the like may be provided on the second conductor layer 32. The current flowing through the metal layer 41, to be described below, is conducted through the second conductor layer 32 to a wiring electrode or the like provided on the second conductor layer 32.

### Metal Layer

The metal layer 41 is a layer containing a metal as a main component and contains silver (Ag) or a silver alloy (Ag alloy). The metal layer 41 has high conductivity, and this eliminates the need for high-temperature heat treatment for increasing the crystallinity of the conductor layers. Thus, this can sufficiently reduce the surface resistance value of the transparent conductive piezoelectric laminate film while preventing performance deterioration of the piezoelectric film. In addition, since the metal layer contains silver (Ag) or a silver alloy (Ag alloy), transmittance can be improved compared with a metal layer made of, for example, Au, Cu, or Al.

Examples of the metal element constituting the Ag alloy include at least one selected from Au, Pd, Nd, Bi, Cu, Sb, Bi, In, Sn, Ge, Nb, Ti, Ru, Al, Ga, and Gd. Examples of a preferred Ag alloy include Ag-Pd, Ag-Cu, Ag-Ge, Ag-Bi, Ag-Nd, Ag-In, and Ag-Nb. Such an Ag alloy may contain an additive, such as another metal element. Thus, the metal layer 41 may contain three or more metal elements. The content of the additive in the metal layer 41 is, for example, 2.5 mass% or less. When the content is above 2.5 mass%, the total light transmittance tends to decrease or the resistance value tends to increase.

From the viewpoint of the transmittance of visible light, the thickness of the metal layer 41 is preferably 20 nm or less and more preferably from 1 to 12 nm.

### Transparent Coating Layer

The transparent conductive piezoelectric laminate film 2 includes, as the pair of transparent coating layers, the first transparent coating layer 21 on a surface of the piezoelectric film 11, the surface on the first conductor layer 31 side of the piezoelectric film 11, and the second transparent coating layer 22 on a surface of the piezoelectric film 11, the surface opposite from the first conductor layer 31 side of the piezoelectric film 11. That is, the transparent conductive piezoelectric laminate film 2 has a laminated structure in which the second transparent coating layer 22, the piezoelectric film 11, the first transparent coating layer 21, the first conductor layer 31, the metal layer 41, and the second conductor layer 32 are layered in this order. The thicknesses, structures, and compositions of the first transparent coating layer 21 and the second transparent coating layer 22 may be the same or different. In addition, it is not always necessary to provide both the first transparent coating layer 21 and the second transparent coating layer 22, and only one of either of them may be provided.

Examples of the transparent coating layer include a hard coat layer, an optical adjustment layer, and an undercoat layer. The transparent coating layer may be a single layer of these or a plurality of layers in combination.

Including the transparent coating layer can further prevent scratches that may occur in the transparent conductive piezoelectric laminate film 2 and further improves the transmittance of the transparent conductive piezoelectric laminate film 2.

The transparent coating layer contains, for example, a resin-cured product obtained by curing a resin composition. The resin composition preferably contains at least one selected from thermosetting resin compositions, ultraviolet-curable resin compositions, and electron beam-curable resin compositions. The resin composition may contain at least one selected from (meth)acrylic ester resins, urethane resins, epoxy-based resins, phenoxy-based resins, and melamine-based resins.

The resin composition is, for example, a composition containing a curable compound having an energy beam-reactive group, such as a (meth)acryloyl group or a vinyl group. The wording "(meth)acryloyl group" means including at least one of an acryloyl group or a methacryloyl group. The curable compound preferably contains a polyfunctional monomer or an oligomer containing two or more and preferably three or more energy beam-reactive groups per molecule.

Using an energy beam-curable resin composition enables the resin composition to be cured by irradiation with an energy beam, such as ultraviolet light. Thus, using such a resin composition is preferred also from the viewpoint of the manufacturing process.

The curable compound preferably contains an acrylic monomer. Examples of the acrylic monomer include urethane-modified acrylates and epoxy-modified acrylates.

The resin composition preferably contains fine particles (organic fine particles and/or inorganic fine particles) from the viewpoints of increasing the strength of the coating film, adjusting the refractive index, increasing the transmittance of the transparent conductive piezoelectric laminate film, and the like. In particular, from the viewpoint of adhesiveness between the transparent coating layer and the first conductor layer, the resin composition more preferably contains inorganic fine particles. Examples of the organic fine particle include organic silicon fine particles, cross-linked acrylic fine particles, and cross-linked polystyrene fine particles. Examples of the inorganic fine particle include synthetic silica particles, talc particles, diatomaceous earth particles, calcium carbonate particles, feldspar particles, quartz particles, aluminum oxide fine particles, zirconium oxide fine particles, titanium oxide fine particles, and iron oxide fine particles.

The average particle size of the fine particle may be 100 nm or less from the viewpoints of being smaller than the thickness of the transparent coating layer and ensuring sufficient transparency. On the other hand, from the viewpoint of producing a colloidal solution, the average particle size may be 5 nm or greater or 10 nm or greater. When an organic fine particle and/or an inorganic fine particle is used, the total amount of the organic fine particle and the inorganic fine particle may be, for example, from 5 to 500 parts by mass or from 20 to 200 parts by mass per 100 parts by mass of the curable compound. In the present specification, the average particle size refers to a volume-based cumulative average particle size (D50) measured by electron microscopy (SEM) method.

A transparent coating layer that is too thin may not be able to sufficiently cover fine surface irregularities of the piezoelectric film and may fail to provide a sufficient effect of reducing the haze of the piezoelectric film. In addition, a transparent coating layer that is too thick may cause insufficient piezoelectricity of the transparent conductive piezoelectric laminate film. Thus, from the viewpoint of reducing the haze of the piezoelectric film, the thicknesses of the first transparent coating layer 21 and the thicknesses of the second transparent coating layer 22 are each preferably 0.20 µm or greater, more preferably 0.35 µm or greater, and still more preferably 0.50 µm or greater. In addition, from the viewpoint of obtaining the transparent conductive piezoelectric laminate film capable of sufficiently exhibiting the piezoelectric characteristics of the piezoelectric film, the thickness of the transparent coating layer is preferably 3.5 µm or less, more preferably 2.5 µm or less, and still more preferably 1.5 µm or less. The transparent coating layer with a thickness in the above ranges can provide both sufficient piezoelectricity and transparency in the transparent conductive piezoelectric laminate film according to the application.

Suitable embodiments of the present invention have been described above, but the present invention is not limited to the embodiments described above. For example, the transparent conductive piezoelectric laminate film 2 described above includes a pair of transparent coating layers but may include only one of either of the first transparent coating layer 21 and the second transparent coating layer 22. In addition, in the transparent conductive piezoelectric laminate films 1 and 2, an optional layer may be provided at any position in addition to the layers described above to the extent that its function is not significantly impaired.

### Applications of Transparent Conductive Piezoelectric Laminate Film

The transparent conductive piezoelectric laminate film according to an embodiment of the present invention is suitably used in a device such as a touch panel of a capacitance type, a resistance film type, or the like.

The device further includes a common display panel unit, such as an LCD, under the transparent conductive piezoelectric laminate film.

The above device is suitably used in display devices of mobile phones, smartphones, personal digital assistants, tablet PCs, notebook personal computers, vending machines, ATMs, FA equipment, OA equipment, medical devices, car navigation systems, and the like.

### Method of Manufacturing Transparent Conductive Piezoelectric Laminate Film

The transparent conductive piezoelectric laminate film according to an embodiment of the present invention can be manufactured by, for example, such a method in which a transparent coating layer is formed on at least one surface of a piezoelectric film as necessary, and a first conductor layer, a metal layer, and a second conductor layer are formed in this order.

The first transparent coating layer can be prepared by applying a solution or dispersion of the resin composition to one surface of the piezoelectric film, drying the solution or dispersion, and curing the resin composition. The application in the preparation can be performed by a known method. Examples of the application method include an extrusion nozzle method, a blade method, a knife method, a bar-coating method, a kiss-coating method, a kiss reverse method, a gravure roll method, a dip method, a reverse roll method, a direct roll method, a curtain method, and a squeeze method. The second transparent coating layer can also be prepared on the other surface of the piezoelectric film in the same manner as the first transparent coating layer.

### Method of Forming Conductor Layers and Metal Layer

The first conductor layer, the second conductor layer, and the metal layer can be formed by a vacuum film forming method, such as a vacuum vapor deposition method, a sputtering method, an ion plating method, or a CVD method. Among these, a sputtering method is preferred since the size of the film formation chamber can be reduced and that a high film formation rate is achieved. Examples of the target that can be used include an oxide target.

Examples of the sputtering gas in the sputtering method include an inert gas, such as Ar. In addition, a reactive gas, such as oxygen gas, can be used in combination as necessary. When a reactive gas is used in combination, the flow rate ratio of the reactive gas is not particularly limited and is, for example, 0.1 flow rate% or more and 5 flow rate% or less relative to a total flow rate ratio of the sputtering gas and the reactive gas.

The atmospheric pressure during sputtering is, for example, 1 Pa or less and preferably 0.7 Pa or less from the viewpoints of preventing a reduction in the sputtering rate, stabilizing discharge, and the like.

The power supply used in the sputtering method may be, for example, any of a DC power supply, an AC power supply, a MF power supply, and an RF power supply, or alternatively may be a combination of these.

The temperature during sputtering is not particularly limited and is preferably 120°C or lower and more preferably 100°C or lower from the viewpoint of heat resistance of the substrate.

### EXAMPLES

The present invention will be further described with reference to examples and comparative examples below, but the present invention is not limited to these examples. The properties of the transparent conductive piezoelectric laminate film according to an embodiment of the present invention were measured by the following methods, and the results are shown in Table 1.

### Surface Resistance

The surface resistance of each transparent conductive piezoelectric laminate film was measured in accordance with JIS K 7194 using a Loresta GP (available from Mitsubishi Chemical Analytech Co., Ltd.). The surface resistance was measured from the second conductor layer side in Examples 1 and 2 and from the conductor layer side in Comparative Example 1.

### Total Light Transmittance

The total light transmittance of each transparent conductive piezoelectric laminate film was measured in accordance with JIS K 7361-1 using a haze meter ("NDH 7000SP II", available from Nippon Denshoku Industries Co., Ltd.).

### Haze Value

The haze value of each transparent conductive piezoelectric laminate film was measured in accordance with JIS K 7136 using a haze meter ("NDH 7000SP II", available from Nippon Denshoku Industries Co., Ltd.).

### Colorimetry

Each transparent conductive piezoelectric laminate film was measured by a method in accordance with JIS Z 8722 using a spectrocolorimeter ("SE 7700", available from Nippon Denshoku Industries Co., Ltd.).

### Adhesiveness

The adhesiveness of each transparent conductive piezoelectric laminate film was evaluated using a cross-cut method. In the conductor layer of each transparent conductive piezoelectric laminate film, 11 vertical lines and 11 horizontal lines at 1-mm intervals were drawn with a utility knife to prepare 100 squares. Then, a tape (Cellotape (trade name) available from Nichiban Co., Ltd., adhesive strength 4.01 N/10 mm) was applied to the conductor layer and peeled off, and a proportion of the conductor layer that peeled off from the piezoelectric film was evaluated according to the following evaluation criteria based on ASTM D3359.
0B: 65% or more peeled off
1 B: 35% or more and less than 65% peeled off
2B: 15% or more and less than 35% peeled off
3B: 5% or more and less than 15% peeled off
4B: less than 5% peeled off
5B: no peeling off

### X-Ray Diffraction Measurement (XRD)

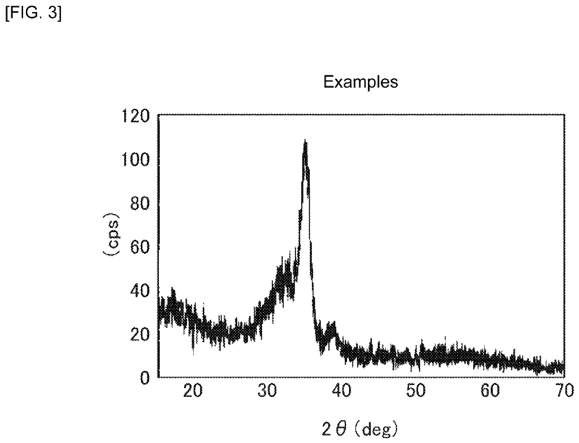

The range of a diffraction angle (2θ) of 15.0 to 70.0° was scanned at a scanning rate of 1°/min using an X-ray diffractometer and measured by an in-plane method. Details of the measurement conditions are described below. The measurement results of Example 1 are shown in FIG. 3. The symbol O indicates that the transparent conductive piezoelectric laminate film had a diffraction peak in the range of 35° ± 2°, and the symbol × indicates that the transparent conductive piezoelectric laminate film had no diffraction peak in the range of 35° ± 2°.

### Measurement Conditions

Apparatus: SmartLab, available from Rigaku Corporation
X-ray source: Cu-Kα (λ = 1.5418 Å) 40 kV 30 mA
Detector: SC-70
Step width: 0.04°
Scan range: from 15.0 to 70.0°
Slit: Incident slit = 0.2 mm
Length limiting slit = 10 mm
Light receiving slit = 20 mm

### Example 1

A resin film (350 mm in width, 200 m in length, and 120 µm in thickness) molded from poly(vinylidene fluoride) (available from Kureha Corporation) with an inherent viscosity of 1.10 dL/g was uniaxially stretched at a stretching ratio of 4.2 times. After stretching, the film was passed through polarization rolls and subjected to a polarization treatment to obtain a piezoelectric film. At that time, the polarization treatment was performed by applying a DC voltage while the DC voltage was increased from 0 kV to 12.0 kV. The film after the polarization treatment was further heat-treated at 130°C for 1 minute, and a transparent piezoelectric film with a thickness of 40 µm was obtained.

An ultraviolet-curable resin composition composed of an acrylic resin and containing amorphous silica (average particle size 80 nm) was applied to one surface (first main surface) of the transparent piezoelectric film with a bar coater and dried at 80°C for 2 minutes. The dried coating film was irradiated with UV at an integrated amount of light of 400 mJ/cm² under a nitrogen atmosphere. Furthermore, the same operation was performed on the other surface, and a film having a first transparent coating layer and a second transparent coating layer each with a thickness of 1.0 µm on either surface was obtained.

A first conductor layer with a thickness of 40 nm was formed on the first transparent coating layer by a reactive sputtering method using a sintered raw material containing 90 mass% of indium oxide and 10 mass% of tin oxide as a target.

A metal layer with a thickness of 8 nm was formed on the first conductor layer by a reactive sputtering method using an Ag alloy (Ag-Pd-Cu-Ge-based) target.

A second conductor layer with a thickness of 40 nm was formed on the metal layer by a reactive sputtering method using a sintered raw material containing 90 mass% of indium oxide and 10 mass% of tin oxide as a target.

A transparent conductive piezoelectric laminate film (the second transparent coating layer/the piezoelectric film/the first transparent coating layer/the first conductor layer/the metal layer/the second conductor layer) as illustrated in FIG. 2 was obtained.

### Example 2

A transparent conductive piezoelectric laminate film (the second transparent coating layer/the piezoelectric film/the first transparent coating layer/the first conductor layer/the metal layer/the second conductor layer) was obtained in the same manner as in Example 1 except that an ultraviolet-curable resin composition composed of an acrylic resin but not containing amorphous silica was used instead of the amorphous silica-containing ultraviolet-curable resin composition composed of an acrylic resin in the formation of the transparent coating layer.

### Comparative Example 1

A transparent piezoelectric film with a thickness of 40 µm was obtained in the same manner as in Example 1.

Then, a transparent conductive piezoelectric laminate film (the piezoelectric film/the conductor layer) was obtained by forming a conductor layer with a thickness of 40 nm on the transparent piezoelectric film by a reactive sputtering method using a sintered raw material containing 90 mass% of indium oxide and 10 mass% of tin oxide as a target.

### Comparative Example 2

A transparent piezoelectric film with a thickness of 40 µm was obtained in the same manner as in Example 1.

An ultraviolet-curable resin composition composed of an acrylic resin and containing amorphous silica (average particle size 80 nm) was applied to one surface (first main surface) of the transparent piezoelectric film with a bar coater and dried at 80°C for 2 minutes. The dried coating film was irradiated with UV at an integrated amount of light of 400 mJ/cm² under a nitrogen atmosphere, and a piezoelectric film having a transparent coating layer with a thickness of 1.0 µm was obtained.

Then, a transparent conductive piezoelectric laminate film (the piezoelectric film/the transparent coating layer/the conductor layer) was obtained by forming a conductor layer with a thickness of 40 nm on the transparent coating layer by a reactive sputtering method using a sintered raw material containing 90 mass% of indium oxide and 10 mass% of tin oxide as a target.

**[Table 1]**

| | Surface resistance | Total light transmittance | Haze value | L* | a* | b* | Adhesiveness | XRD |
|---|---|---|---|---|---|---|---|---|
| | [Ω/sq] | % | % | [-] | [-] | [-] | | |
| Example 1 | 11 | 86.9 | 0.5 | 94.3 | -0.9 | 1.4 | 5B | ○ |
| Example 2 | 18 | 86.6 | 0.3 | 94.0 | -0.5 | 1.2 | 2B | ○ |
| Comparative Example 1 | 125 | 80.1 | 2.0 | 91.5 | 0.5 | 5.0 | - | × |
| Comparative Example 2 | 240 | 77.0 | 1.4 | 90.6 | 0.7 | 5.1 | 5B | × |

As shown in Table 1, in the examples, the transparent conductive piezoelectric laminate films each exhibited low surface resistance, high total light transmittance, low haze value, and high brightness. Thus, this confirmed that a transparent conductive piezoelectric laminate film that achieves high transparency and low resistance can be obtained by the present invention.

On the other hand, for comparative examples obtained in the same manner as in Example 1 except that Cu or Al was used as the metal layer instead of the Ag alloy, the transmittance at 550 nm was 72% and 39%, respectively (Example 1: 87%).

In addition, for reference examples obtained in the same manner as in Example 1 except that the thickness of the metal layer was 5 nm or 10 nm, the transmittance at 550 nm was 86% and 85%, respectively (Example 1: 87%).

### REFERENCE SIGNS LIST

1, 2: Transparent conductive piezoelectric laminate film
11: Piezoelectric film
21: First transparent coating layer
22: Second transparent coating layer
31: First conductor layer
32: Second conductor layer
41: Metal layer

## Claims

1. A transparent conductive piezoelectric laminate film, wherein
a piezoelectric film, a first conductor layer, a metal layer, and a second conductor layer are layered in this order, and
the metal layer comprises silver or a silver alloy.

2. The transparent conductive piezoelectric laminate film according to claim 1, wherein the transparent conductive piezoelectric laminate film has a diffraction peak in a range of 35° ± 2° in X-ray diffraction measurement.

3. The transparent conductive piezoelectric laminate film according to claim 1, wherein a surface resistance measured from the second conductor layer side is 30 Ω/sq or less.

4. The transparent conductive piezoelectric laminate film according to claim 1, wherein the piezoelectric film comprises a fluorine-based resin.

5. The transparent conductive piezoelectric laminate film according to claim 1, wherein a thickness of the metal layer is from 1 to 12 nm.

6. The transparent conductive piezoelectric laminate film according to claim 1, wherein a total light transmittance is 85% or more.

7. The transparent conductive piezoelectric laminate film according to claim 1, wherein b* in a L*a*b* color system is from -3 to 3.

8. The transparent conductive piezoelectric laminate film according to claim 1, further comprising a transparent coating layer on a surface of the piezoelectric film, the surface on the first conductor layer side of the piezoelectric film.

9. The transparent conductive piezoelectric laminate film according to claim 8, wherein the transparent coating layer comprises a fine particle.

10. A device comprising the transparent conductive piezoelectric laminate film described in any one of claims 1 to 9.
